# FASCICULE DE BREVET EUROPEEN

(11) **EP 2 244 167 B1**
(45) Date de publication et mention de la délivrance du brevet: **05.05.2021**
(21) Numéro de dépôt: 10004039.3
(22) Date de dépôt: 16.04.2010
(51) Int. Cl.: G06F 3/01, H01H 13/85

(54) **Dispositif de commande à retour haptique**
Steuervorrichtung mit haptischer Rückmeldung
CONTROL DEVICE WITH HAPTIC FEEDBACK

(30) Priorité: 20.04.2009 FR 0901901
(43) Date de publication de la demande: 27.10.2010
(73) Titulaire: DAV, 94000 Creteil (FR)
(72) Inventeur: Marie, Bruno, 74380 Cranves Sales (FR)

(56) Documents cités:
- EP-A1- 0 419 326
- EP-A2- 2 113 824
- WO-A2-2009/130188
- DE-A1- 10 234 863
- DE-A1-102004 029 718
- US-A1- 2005 017 947

## Description

La présente invention concerne un dispositif de commande pour véhicule automobile, permettant notamment de transmettre un retour haptique à un utilisateur, tel qu'un retour vibratoire.

Dans le domaine automobile, des dispositifs de commande multifonction, réalisés par exemple sous la forme d'un joystick ou d'un bouton rotatif, sont de plus en plus utilisés pour commander des systèmes électriques ou électroniques, tels qu'un système de climatisation, un système audio ou encore un système de navigation.

De tels dispositifs peuvent être associés à un écran d'affichage et permettre une navigation dans des menus déroulants comportant différentes commandes relatives aux systèmes à commander.

Pour augmenter le confort ergonomique, l'utilisation d'une technologie à capteur à surface tactile au niveau de la surface de commande de tels dispositifs de commande peut être considérée comme un développement intéressant.

Lorsqu'un utilisateur exerce une pression sur la surface tactile d'un tel capteur, on peut mesurer la pression appliquée et/ou déterminer la localisation de l'endroit où la pression est exercée par application d'une tension électrique adaptée. Dans ce cas, un appui de l'utilisateur sur la surface tactile est par exemple associé à la sélection d'une commande.

En outre, pour signaler à l'utilisateur que sa commande a bien été prise en compte, notamment en conduite de nuit ou lors d'une manipulation en aveugle, il est important que l'utilisateur ait un retour haptique de manière à rester concentré sur la route.

Pour cela, on connaît déjà des dispositifs de commande à retour haptique comportant des actionneurs, tels que des actionneurs électromagnétiques, reliés une plaque portant le capteur à surface tactile du dispositif de commande pour transmettre un mouvement de vibration à la surface tactile, de manière que l'utilisateur perçoive un retour haptique l'informant que sa commande a bien été prise en compte. Les documents WO 2009/130188 A2, EP 2 113 824 A2 et US 2005/017947 décrivent de tels dispositifs de commande à retour haptique.

Ces dispositifs de commande doivent en outre pouvoir répondre à des contraintes spécifiques de certains domaines, comme le domaine automobile, pour lequel les dispositifs de commande doivent être capables de résister à d'importants efforts, tel qu'un coup accidentel donné à un dispositif de commande situé près du siège du conducteur.

Pour cela, certains dispositifs de commande connus utilisent des moyens de guidage fixés à un châssis du dispositif. Ces moyens permettent le guidage en translation de la plaque et en outre le maintien de la plaque de manière à éviter la détérioration de l'actionneur fixé à la plaque en cas d'effort brutal appliqué au dispositif.

Toutefois, ces moyens présentent l'inconvénient d'être à l'origine de problèmes hyperstatiques tendant à faire diminuer le rendement global du dispositif.

En effet, l'assemblage de la plaque d'une part aux actionneurs fixés au châssis et d'autre part aux moyens de guidage également fixés au châssis, engendre une multitude de fixations mécaniques.

L'invention a donc pour objectif de proposer un dispositif de commande à retour haptique amélioré ne présentant pas les inconvénients de l'art antérieur, assurant une liaison mécanique optimale entre la plaque et le châssis répondant aux exigences de normes et présentant un faible encombrement et un faible coût.

À cet effet, l'invention a pour objet un dispositif de commande à retour haptique comportant :
- une plaque pour transmettre un retour haptique à un utilisateur,
- un capteur à surface tactile porté par la plaque, configuré pour détecter un appui de l'utilisateur sur la surface tactile, et
- au moins un actionneur comportant :
   - un noyau mobile relié à la plaque configuré pour entraîner la plaque en mouvement lorsqu'un appui est détecté sur la surface tactile de manière à générer le retour haptique, et
   - un stator fixé à un châssis dudit dispositif et comprenant deux armatures entre lesquelles le noyau mobile est entraîné en translation lorsque le retour haptique est généré,
caractérisé en ce que lesdites armatures forment un support de la plaque et en ce que lesdites armatures portent des moyens de guidage de la plaque intercalés entre lesdites armatures et la plaque, pour permettre le mouvement de la plaque par rapport au stator lorsque le retour haptique est généré, selon une direction d'entraînement parallèle au plan (P) défini par la plaque (3).

On réalise ainsi un dispositif de commande avec un faible encombrement dont le moyen de guidage de la plaque est intégré à l'actionneur de façon à diminuer les liaisons mécaniques entre le châssis et la plaque.

Le dispositif de commande peut en outre comporter une ou plusieurs caractéristiques suivantes, prises séparément ou en combinaison :
- lesdits moyens de guidage comportent des moyens de rappel élastiques, tels que des élastomères,
- lesdits moyens de guidage comportent respectivement une bande de feutrine intercalée entre les moyens de rappel élastiques et la plaque,
- lesdits moyens de rappel élastiques sont surmoulés sur lesdites armatures.
- ledit actionneur est électromagnétique et comporte au moins une bobine configurée pour générer un champ magnétique lorsqu'elle est alimentée, et lesdites armatures sont réalisées en matériau ferromagnétique, de sorte que ledit champ magnétique guide le noyau mobile en translation entre lesdites armatures et que les lignes de champ magnétique générées bouclent dans lesdites armatures,
- le noyau mobile comporte au moins deux bobines fixées dos à dos dans un corps commun,
- ledit actionneur comporte au moins deux bobines fixées au stator commun et en ce que le noyau mobile est réalisé en matériau ferromagnétique,
- lesdites armatures présentent respectivement une ouverture formant un logement pour recevoir une extrémité associée du noyau mobile, de manière à assurer le guidage mécanique du noyau mobile lorsque le retour haptique est généré,
- le noyau mobile présente un corps sensiblement cylindrique et en ce que ladite ouverture forme un logement annulaire,
- chacune desdites armatures présente une forme générale sensiblement en U avec une base centrale fixée au châssis et deux branches latérales s'étendant depuis ladite base perpendiculairement au plan défini par la plaque.

D'autres caractéristiques et avantages de l'invention ressortiront de la description suivante, donnée à titre d'exemple, sans caractère limitatif, en regard des dessins annexés sur lesquels :
- la figure 1 illustre un dispositif de commande à retour haptique comportant un actionneur selon un premier mode de réalisation,
- la figure 2 est une vue de côté du dispositif de la figure 1,
- la figure 3 est une vue en perspective du dispositif de la figure 1, et
- la figure 4 représente un actionneur selon un deuxième mode de réalisation.

L'invention concerne un dispositif de commande à retour haptique, par exemple pour un tableau de commande de véhicule automobile, ou encore pour console centrale de véhicule automobile, permettant de commander des systèmes électriques ou électroniques du véhicule, et pouvant transmettre un retour haptique à un utilisateur ayant par exemple modifié ou sélectionné une commande de manière à assurer à l'utilisateur la prise en compte de la commande modifiée ou sélectionnée.

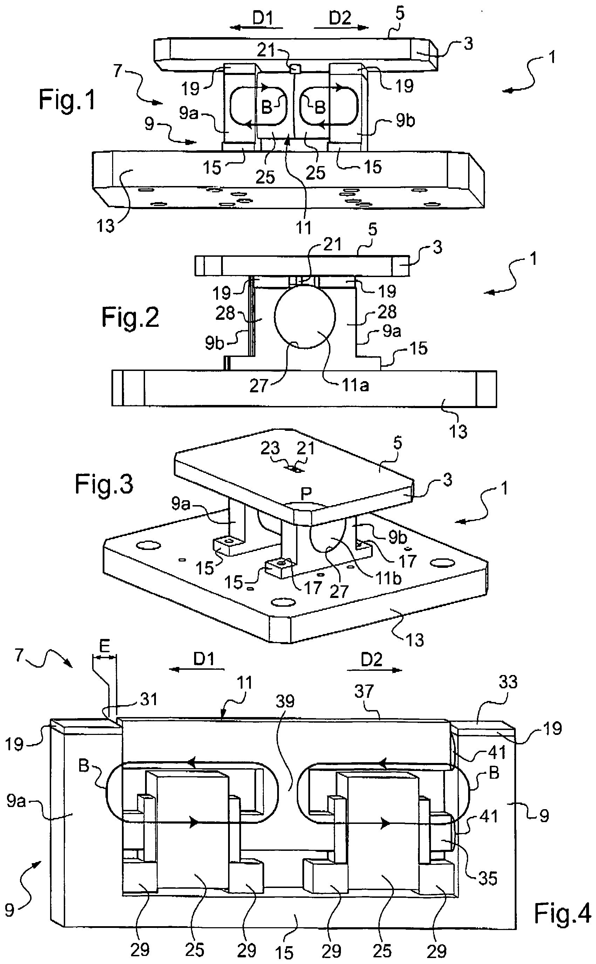

Comme l'illustrent les figures 1 à 3, le dispositif 1 comporte :
- une plaque 3 de support configurée pour transmettre un retour haptique à un utilisateur, par exemple à un doigt d'un utilisateur,
- un capteur 5 à surface tactile porté par la plaque 3 et configuré pour détecter un appui de l'utilisateur sur la surface tactile, et
- un actionneur 7 relié à la plaque 3 pour appliquer un mouvement de vibration à la plaque 3 lorsqu'un appui est détecté, de manière à générer le retour haptique à l'utilisateur.

Le capteur 5 à surface tactile est par exemple un capteur de pression utilisant la technologie FSR pour "Force Sensing Resistor" en anglais, c'est-à-dire utilisant des résistances sensibles à la pression. On pourrait également choisir un capteur utilisant une technologie capacitive ou optique pour détecter un appui de l'utilisateur.

Une peau de protection et de décoration (non représentée) peut être disposée sur ce capteur 5 à surface tactile.

Par ailleurs, une unité de pilotage (non représentée) reliée au capteur 5 et à l'actionneur 7 est utilisée pour fournir un signal de commande à l'actionneur 7 de façon à entraîner la plaque 3 en mouvement selon une direction d'entraînement D1 ou D2, lorsqu'un appui est détecté sur la surface tactile. La direction d'entraînement est parallèle au plan P défini par la plaque 3.

Le signal de commande est par exemple sinusoïdal ou comporte un ou une succession de pulses.

On peut prévoir un pilotage de l'actionneur 7 pour entraîner la plaque 3 en translation alternativement dans deux directions D1,D2 opposées pour générer un retour haptique vibratoire.

Par ailleurs, pour une meilleure répartition des efforts appliqués à la plaque 3, on peut prévoir un nombre pair d'actionneurs 7 disposés deux à deux en vis-à-vis sur des côtés opposés de la plaque 3.

L'actionneur 7 comprend un stator 9 et un noyau mobile 11 à l'intérieur du stator 9. Le stator 9 est solidaire d'un châssis 13 du dispositif 1, et le noyau mobile 11 est relié à la plaque 3 pour l'entraîner en mouvement lorsqu'un appui est détecté.

Le stator 9 présente une première 9a et une seconde 9b armatures respectivement disposées en regard d'une première 11a et d'une seconde 11b extrémités du noyau mobile 11. Chaque armature 9a,9b peut présenter une base 15 fixée sur le châssis 13. A cet effet, on prévoit des moyens de fixation sur la base 15, tels qu'une paire de trous taraudés 17 pour un vissage sur le châssis 13.

Bien sûr, les deux armatures 9a,9b peuvent être reliées par une base 15 commune.

En outre, ces armatures 9a,9b servent de support pour maintenir la plaque 3 et éviter la détérioration de l'actionneur 7 par exemple en cas d'un appui trop fort sur la surface tactile.

De plus, des moyens de guidage 19 sont portés par les armatures 9a,9b en étant en contact avec la plaque 3 (figures 1 et 2).

Ces moyens de guidage 19, comportant par exemple chacun un moyen de rappel élastique tel qu'un élastomère et une bande de feutrine en contact avec la plaque 3, assurent le guidage du mouvement de la plaque lorsque le retour haptique est généré et évitent tout contact physique entre la plaque 3 et le stator 9 de manière à limiter le bruit généré lors d'un appui sur la surface tactile et lors du mouvement de la plaque 3.

Pour faciliter la production de l'actionneur 7, on peut prévoir que les élastomères sont surmoulés sur les armatures 9a,9b.

En outre, le déplacement de la plaque 3 est limité par ces moyens de guidage 19 sans nécessiter de mettre en oeuvre des butées de fin de course de la plaque 3.

Ainsi, le moyen de guidage étant porté par le stator 9, les fixations mécaniques entre le châssis et la plaque 3 sont réduites, limitant les risques de problèmes hyperstatiques.

Par ailleurs, on peut prévoir un jeu mécanique entre la plaque 3 et un moyen de liaison solidaire du noyau mobile 11 pour faciliter l'assemblage de l'actionneur 7.

Par exemple, le moyen de liaison est sous la forme d'une tige 21 qui coopère avec avec une ouverture oblongue 23 correspondante (voir figure 3) ménagée sur la plaque 3. À cet effet, le noyau mobile 11 peut présenter un trou taraudé pour la fixation de la tige 21. Une fois l'assemblage réalisé, la tige 21 est fixée à la plaque 3 pour permettre la transmission du mouvement du noyau mobile 11 à la plaque 3.

En outre, l'actionneur 7 peut être un actionneur électromagnétique. Dans ce cas, l'actionneur 7 comporte au moins une bobine 25 pour générer un champ magnétique B lorsqu'elle est alimentée. Le champ magnétique B ainsi généré permet de guider le noyau mobile en translation entre les armatures 9a,9b.

Cette bobine 25 est fixée au noyau mobile 11 qui coulisse à l'intérieur du stator 9 sous l'effet du champ magnétique B créé. Les armatures 9a,9b sont alors réalisées en matériau ferromagnétique et les lignes de champ magnétique B générées par la bobine 25 bouclent dans ces armatures 9a,9b. Le noyau mobile 11 et les armatures 9a,9b du stator 9 forment alors un circuit magnétique fermé.

Ainsi, les armatures 9a,9b assurent plusieurs fonctions distinctes, notamment la fixation de l'actionneur 7 sur le châssis 13, le maintien de la plaque et le rebouclage des lignes de champ magnétique permettant de générer le retour haptique.

Pour un moindre coût de production, de telles armatures 9a,9b multifonctions peuvent être réalisées par moulage en utilisant par exemple de la poudre ferromagnétique.

Dans l'exemple illustré, l'actionneur 7 comporte deux bobines 25 disposées dos à dos dans un corps commun du noyau mobile 11. Les deux bobines 25 coopèrent alors respectivement avec la première 9a et la seconde 9b armatures de l'actionneur 7 pour entraîner la plaque 3 en translation selon une direction d'entraînement commune D1 ou D2.

En alternative, on peut prévoir un pilotage indépendant et/ou déphasés des deux bobines 25, par exemple pour générer un effet de freinage en fin de course.

Comme l'illustre la figure 1 de façon schématique, le stator 9 présente alors deux parties de circuits magnétiques en forme de U guidant les lignes des champs magnétiques B respectivement générés par les deux bobines 25.

Par ailleurs, pour un tel actionneur 7 à double bobine 25, on assure un retour haptique uniforme en le disposant de façon que son milieu soit sensiblement en regard du milieu de la plaque 3. Pour cela, le trou taraudé prévu sur le noyau mobile pour la fixation de la tige 21 se situe au niveau de la jonction des deux bobines 25 sensiblement au milieu du noyau mobile 11.

Par ailleurs, les armatures 9a,9b peuvent présenter chacune une ouverture 27 dans laquelle l'extrémité 11a,11b associée du noyau mobile 11 est logée. Le noyau mobile 11 est alors guidé mécaniquement par les armatures 9a,9b.

L'ouverture 27 présente une forme complémentaire de la forme des extrémités 11a, 11b du noyau mobile 11. Dans l'exemple illustré, le noyau mobile 11 présente un corps sensiblement cylindrique et l'ouverture 27 forme un logement sensiblement annulaire pour l'extrémité 11a, 11b associée.

Plus précisément, les armatures 9a,9b présentent par exemple une forme générale sensiblement en U avec deux branches latérales 28 s'étendant depuis la base 15 perpendiculairement au plan P défini par la plaque 3, en regard de l'extrémité 11a, 11b associée du noyau mobile 11, de manière à former un logement pour cette extrémité 11a, 11b. Dans ce cas, un moyen de guidage 19 est disposé entre chaque branche 28 et la plaque 3.

Ainsi, le stator 9 de l'actionneur 7 selon le premier mode de réalisation illustré porte quatre moyens de guidage 19.

Bien entendu, on peut prévoir en alternative que les armatures 9a,9b présentent des butées de fin de course du noyau mobile 11.

On a représenté sur la figure 4, un deuxième mode de réalisation de l'actionneur 7, qui diffère du premier mode de réalisation par le fait que les bobines 25 sont fixées au stator 9 commun.

Dans l'exemple illustré sur la figure 4, deux bobines 25 sont montées autour d'un axe 35 de l'actionneur 7 et sont maintenues par des supports 29 fixés au stator 9, plus précisément à la base 15 reliant les deux armatures 9a,9b.

Le noyau mobile 11 est alors réalisé en matériau ferromagnétique et est mobile dans un entrefer E du stator 9. À titre d'exemple, l'entrefer E est de l'ordre de 0,2 à 0,5 millimètres.

Plus précisément, le noyau 11 est mobile en translation entre une première 31 et une deuxième 33 butées respectivement prévues sur la première 9a et la seconde 9b armatures du stator 9 et parallèlement à l'axe 35.

Dans l'exemple illustré, l'axe 35 et le noyau mobile 11 sont confondus et les bobines 21 sont disposées autour de l'axe 35 du noyau mobile 11 qui possède en outre un axe supplémentaire 37. Les deux axes 35,37 sont parallèles et perpendiculairement reliés entre eux par un tronc commun 39 du noyau mobile 11 disposé entre les deux bobines 21, par exemple au milieu de l'axe 35 et de l'axe supplémentaire 37, pour former deux circuits magnétiques entre le stator 9 et le noyau mobile 11.

Comme on le constate sur la figure 4, les axes 35,37 et le tronc commun 39 du noyau mobile 11 forment un noyau 11 en une seule pièce.

On peut également disposer un amortisseur 41 dans chaque entrefer E situé entre le noyau mobile 11 et les armatures 9a,9b du stator 9. Ainsi, l'actionneur 7 présente quatre amortisseurs 41, dont deux sont visibles sur le côté droit de la figure 4.

Les amortisseurs 41, de préférence en silicone ou en élastomère, permettent d'amortir d'éventuels contacts entre le noyau mobile 11 et le stator 9, notamment au démarrage de l'actionneur 7, limitant ainsi d'éventuels bruits résultants de ce contact.

De manière à être compatible aux normes automobiles, un amortisseur 41 présente une épaisseur de l'ordre de 0.2 à 0.5 mm.

En outre, ces amortisseurs 41 peuvent être surmoulés sur les armatures 9a,9b.

De plus, le corps de chaque bobine 25 forme un guide axialement à l'axe 35 pour le déplacement du noyau mobile 11, ce qui permet de renforcer la tenue mécanique de l'actionneur 7.

On comprend donc qu'un tel dispositif de commande avec des armatures multifonctions permet de fournir, sans perte de rendement et à moindre coût, un effet haptique à un utilisateur, en limitant les fixations mécaniques entre le châssis 13 et la plaque 3 tout en respectant les normes de sécurité.

## Revendications

1. Dispositif de commande à retour haptique comportant :
- une plaque (3) pour transmettre un retour haptique à un utilisateur,
- un capteur (5) à surface tactile porté par la plaque (3), configuré pour détecter un appui de l'utilisateur sur la surface tactile, et
- au moins un actionneur (7) comportant :
• un noyau mobile (11) relié à la plaque (3) configuré pour entraîner la plaque (3) en mouvement lorsqu'un appui est détecté sur la surface tactile de manière à générer le retour haptique, et
• un stator (9) fixé à un châssis (13) dudit dispositif et comprenant deux armatures (9a,9b) entre lesquelles le noyau mobile (11) est entraîné en translation lorsque le retour haptique est généré,
lesdites armatures (9a,9b) formant un support de la plaque (3),
le dispositif de commande étant **caractérisé en ce que**
lesdites armatures (9a,9b) portent des moyens de guidage (19) de la plaque (3) intercalés entre lesdites armatures (9a,9b) et la plaque (3), pour permettre le mouvement de la plaque (3) par rapport au stator (9) lorsque le retour haptique est généré, selon une direction d'entraînement parallèle au plan (P) défini par la plaque (3).

2. Dispositif selon la revendication 1, **caractérisé en ce que** lesdits moyens de guidage (19) comportent des moyens de rappel élastiques, tels que des élastomères.

3. Dispositif selon la revendication 2, **caractérisé en ce que** lesdits moyens de guidage (19) comportent respectivement une bande de feutrine intercalée entre les moyens de rappel élastiques et la plaque (3).

4. Dispositif selon l'une des revendications 2 ou 3, **caractérisé en ce que** lesdits moyens de rappel élastiques sont surmoulés sur lesdites armatures (9a,9b).

5. Dispositif selon l'une quelconque des revendications précédentes **caractérisé en ce que** :
- ledit actionneur (7) est électromagnétique et comporte au moins une bobine (25) configurée pour générer un champ magnétique lorsqu'elle est alimentée, et **en ce que**
- lesdites armatures (9a,9b) sont réalisées en matériau ferromagnétique,
de sorte que ledit champ magnétique guide le noyau mobile (11) en translation entre lesdites armatures (9a,9b) et que les lignes de champ magnétique générées bouclent dans lesdites armatures (9a,9b).

6. Dispositif selon la revendication 5, **caractérisé en ce que** le noyau mobile (11) comporte au moins deux bobines (25) fixées dos à dos dans un corps commun.

7. Dispositif selon la revendication 5, **caractérisé en ce que** ledit actionneur (7) comporte au moins deux bobines (25) fixées au stator (9) commun et **en ce que** le noyau mobile (11) est réalisé en matériau ferromagnétique.

8. Dispositif selon l'une quelconque des revendications précédentes, **caractérisé en ce que** lesdites armatures (9a,9b) présentent respectivement une ouverture (27) formant un logement pour recevoir une extrémité (11a,11b) associée du noyau mobile (11), de manière à assurer le guidage mécanique du noyau mobile (11) lorsque le retour haptique est généré.

9. Dispositif selon la revendication 8, **caractérisé en ce que** le noyau mobile (11) présente un corps sensiblement cylindrique et **en ce que** ladite ouverture (27) forme un logement annulaire.

10. Dispositif selon l'une des revendications 8 ou 9, **caractérisé en ce que** chacune desdites armatures (9a,9b) présente une forme générale sensiblement en U avec une base (15) centrale fixée au châssis (13) et deux branches latérales (28) s'étendant depuis ladite base (15) perpendiculairement au plan (P) défini par la plaque (3).

## Patentansprüche

1. Steuervorrichtung mit haptischer Rückmeldung, die Folgendes umfasst:
- eine Platte (3), um eine haptische Rückmeldung an einen Benutzer zu übertragen,
- einen Sensor (5) mit berührungsempfindlicher Oberfläche, der von der Platte (3) getragen wird und dazu konfiguriert ist, einen Druck des Benutzers auf die berührungsempfindliche Oberfläche zu detektieren, und
- mindestens ein Stellglied (7), das Folgendes umfasst:
• einen beweglichen Kern (11), der mit der Platte (3) verbunden ist und dazu konfiguriert ist, die Platte (3) beweglich anzutreiben, wenn ein Druck auf die berührungsempfindliche Oberfläche detektiert wird, um die haptische Rückmeldung zu erzeugen, und
• einen Stator (9), der an einem Rahmen (13) der Vorrichtung befestigt ist und zwei Glieder (9a, 9b) beinhaltet, zwischen denen der bewegliche Kern (11) translatorisch angetrieben wird, wenn die haptische Rückmeldung erzeugt wird,
wobei die Glieder (9a, 9b) eine Stütze der Platte (3) bilden,
wobei die Steuervorrichtung **dadurch gekennzeichnet ist, dass** die Glieder (9a, 9b) Mittel zum Führen (19) der Platte (3) tragen, die zwischen den Gliedern (9a, 9b) und der Platte (3) eingefügt sind, um, wenn die haptische Rückmeldung erzeugt wird, die Bewegung der Platte (3) mit Bezug auf den Stator (9) gemäß einer Antriebsrichtung, die parallel zu der durch die Platte (3) definierten Ebene (P) verläuft, zu gestatten.

2. Vorrichtung nach Anspruch 1, **dadurch gekennzeichnet, dass** die Führungsmittel (19) elastische Rückstellmittel, wie etwa Elastomere, umfassen.

3. Vorrichtung nach Anspruch 2, **dadurch gekennzeichnet, dass** die Führungsmittel (19) jeweils einen Filzstreifen umfassen, der zwischen den elastischen Rückstellmitteln und der Platte (3) eingefügt ist.

4. Vorrichtung nach einem der Ansprüche 2 oder 3, **dadurch gekennzeichnet, dass** die elastischen Rückstellmittel auf die Glieder (9a, 9b) aufgeformt sind.

5. Vorrichtung nach einem der vorhergehenden Ansprüche, **dadurch gekennzeichnet, dass**:
- das Stellglied (7) elektromagnetisch ist und mindestens eine Spule (25) umfasst, die dazu konfiguriert ist, ein Magnetfeld zu erzeugen, wenn sie mit Strom versorgt wird, und dass
- die Glieder (9a, 9b) aus einem ferromagnetischen Material hergestellt sind, sodass das Magnetfeld den beweglichen Kern (11) translatorisch zwischen den Gliedern (9a, 9b) führt und sodass die erzeugten Magnetfeldlinien in den Gliedern (9a, 9b) eine Schleife bilden.

6. Vorrichtung nach Anspruch 5, **dadurch gekennzeichnet, dass** der bewegliche Kern (11) mindestens zwei Spulen (25) umfasst, die in einem gemeinsamen Körper Rücken an Rücken befestigt sind.

7. Vorrichtung nach Anspruch 5, **dadurch gekennzeichnet, dass** das Stellglied (7) mindestens zwei Spulen (25) umfasst, die an dem gemeinsamen Stator (9) befestigt sind, und dass der bewegliche Kern (11) aus einem ferromagnetischen Material hergestellt ist.

8. Vorrichtung nach einem der vorhergehenden Ansprüche, **dadurch gekennzeichnet, dass** die Glieder (9a, 9b) jeweils eine Öffnung (27) aufweisen, die eine Aufnahme zum Aufnehmen eines assoziierten Endes (11a, 11b) des beweglichen Kerns (11) bildet, um die mechanische Führung des beweglichen Kerns (11) sicherzustellen, wenn die haptische Rückmeldung erzeugt wird.

9. Vorrichtung nach Anspruch 8, **dadurch gekennzeichnet, dass** der bewegliche Kern (11) einen im Wesentlichen zylindrischen Körper aufweist und dass die Öffnung (27) eine ringförmige Aufnahme bildet.

10. Vorrichtung nach einem der Ansprüche 8 oder 9, **dadurch gekennzeichnet, dass** jedes der Glieder (9a, 9b) eine im Wesentlichen U-förmige Grundform mit einer am Rahmen (13) befestigten mittigen Basis (15) und zwei Seitenarmen (28), die sich von der Basis (15) senkrecht zu der durch die Platte (3) definierten Ebene (P) erstrecken, aufweist.

## Claims

1. Control device with haptic feedback comprising:
- a plate (3) for transmitting haptic feedback to a user,
- a touch surface sensor (5) borne by the plate (3), configured to detect a touch of the user on the touch surface, and
- at least one actuator (7) comprising:
• a movable core (11) linked to the plate (3) configured to drive the plate (3) in movement when a touch is detected on the touch surface so as to generate the haptic feedback, and
• a stator (9) fixed to a frame (13) of said device and comprising two armatures (9a, 9b) between which the movable core (11) is driven in translation when the haptic feedback is generated,
said armatures (9a, 9b) forming a support for the plate (3),
the control device being **characterized in that** said armatures (9a, 9b) bear the guiding means (19) of the plate (3) inserted between said armatures (9a, 9b) and the plate (3), to allow the movement of the plate (3) with respect to the stator (9) when the haptic feedback is generated, in a driving direction parallel to the plane (P) defined by the plate (3).

2. Device according to Claim 1, **characterized in that** said guiding means (19) comprise elastic return means such as elastomers.

3. Device according to Claim 2, **characterized in that** said guiding means (19) comprise, respectively, a strip of baize inserted between the elastic return means and the plate (3).

4. Device according to one of Claims 2 and 3, **characterized in that** said elastic return means are overmoulded on said armatures (9a, 9b).

5. Device according to any one of the preceding claims, **characterized in that**:
- said actuator (7) is electromagnetic and comprises at least one coil (25) configured to generate a magnetic field when it is powered, and **in that**
- said armatures (9a, 9b) are made of ferromagnetic material,
such that said magnetic field guides the movable core (11) in translation between said armatures (9a, 9b) and that the generated magnetic field lines loop in said armatures (9a, 9b).

6. Device according to Claim 5, **characterized in that** the movable core (11) comprises at least two coils (25) fixed back-to-back in a common body.

7. Device according to Claim 5, **characterized in that** said actuator (7) comprises at least two coils (25) fixed to the common stator (9) and **in that** the movable core (11) is made of ferromagnetic material.

8. Device according to any one of the preceding claims, **characterized in that** said armatures (9a, 9b) have, respectively, an opening (27) forming a housing for receiving an associated end (11a, 11b) of the movable core (11), so as to ensure the mechanical guiding of the movable core (11) when the haptic feedback is generated.

9. Device according to Claim 8, **characterized in that** the movable core (11) has a substantially cylindrical body and **in that** said opening (27) forms an annular housing.

10. Device according to one of Claims 8 and 9, **characterized in that** each of said armatures (9a, 9b) has a generally substantially U-shaped form with a central base (15) fixed to the frame (13) and two lateral branches (28) extending from said base (15) at right angles to the plane (P) defined by the plate (3).
